# FASCICULE DE BREVET EUROPEEN

(11) **EP 0 359 598 B1**
(45) Date de publication et mention de la délivrance du brevet: **12.01.1994**
(21) Numéro de dépôt: 89402057.7
(22) Date de dépôt: 19.07.1989
(51) Int. Cl.: G01R 33/24, G01R 33/60

(54) **Procédé de caractérisation de matériaux pour leur utilisation en magnétométrie à résonance, spectromètre pour cette caractérisation et procédé de calibration de ce spectromètre**
Verfahren zur Charakterisierung von Materialien für die Verwendung in der Resonanz-Magnetometrie, Spektrometer für diese Charakterisierung und Verfahren zur Eichung dieses Spektrometers
Method for the characterization of materials for their use in resonance magnetometers, spectrometer for this characterization and method for the calibration of this spectrometer

(30) Priorité: 20.07.1988 FR 8809830
(43) Date de publication de la demande: 21.03.1990
(73) Titulaire: COMMISSARIAT A L'ENERGIE ATOMIQUE, 75015 Paris Cédex 15 (FR)
(72) Inventeur: Duret, Denis, F-38000 Grenoble (FR); Beranger, Marc, F-38240 Meylan (FR)
(74) Mandataire: Mongrédien, André

(56) Documents cités:
- EP-A- 0 163 779
- US-A- 3 648 157
- REVUE DE PHYSIQUE APPLIQUEE, vol. 7, no. 1, mars 1972, page 23-27, Paris, FR; D. BOURDEL et al.: "Amélioration de la sensibilité des magnétomètres a résonance paramagnétique"
- ZEITSCHRIFT FÜR ANGEWANDTE PHYSIK, vol. 28, no. 6, 1970, pages 344-352, Berlin, DE; H. HENRICH et al.: "Untersuchung von ESR-Dispersionslinienformen mit linear und zirkular polarisierten Hochfrequenzfeldern"
- REVUE DE PHYSIQUE APPLIQUEE, vol. 11, no. 5, septembre 1976, pages 629-637; P. ACKERMANN et al.: "Dispositif digital d'étalonnage d'un champ magnétique application à la spectroscopie R.P.E."
- NUCLEAR INSTRUMENTS AND METHODS, vol. 143, no. 2, 1977, pages 219-225, North Holland Publishing Co., Amsterdam, NL; K. BORER et al.: "Absolute calibration of the NMR magnetometers and of the magnetic field measuring system used in the cern muon storage ring"
- IEEE TRANSACTIONS ON MAGNETICS, vol. 8, no. 1, mars 1972, pages 66-75, New York, US; F. HARTMANN: "Resonance magnetometers"

## Description

La présente invention a pour objet un procédé de caractérisation de matériaux pour leur utilisation en magnétométrie à résonance, un spectromètre pour cette caractérisation ainsi qu'un procédé de calibration de ce spectromètre. Elle s'applique notamment à la classification de matériaux pour leur utilisation en magnétométrie à résonance paramagnétique électronique.

L'amélioration des performances des magnétomètres à résonance passe par la recherche de matériaux nouveaux pour la détection de la résonance. Si le chimiste les fabrique, il appartient au physicien de fournir une méthode pour les classer par ordre de mérite. Ce classement permet d'orienter les recherches du chimiste et d'obtenir un magnétomètre dont les caractéristiques sont parfaitement déterminées.

Jusqu'à ce jour, le seul classement retenu pour sélectionner les matériaux en vue d'une utilisation en magnétométrie consistait à mesurer leur largeur de raie d'absorption autour d'une fréquence de référence fr. Hartmann dans son article "Resonance Magnetomers" paru dans la revue IEEE transactions on magnetics, vol. MAG-8, n° 1, March 1972 montre que la sensibilité maximum d'un magnétomètre est obtenue avec un matériau dont la largeur de raie d'absorption est la plus faible possible.

Par ailleurs, ces mesures de largeur de raie sont effectuées dans des spectromètres utilisant des fréquences de référence fr situées autour de 9 GHz. Cette valeur de fr correspond à un champ fort : elle est reliée à un champ magnétique Bo par l'égalité fr = γBo où γ est le rapport gyromagnétique (2,8 10¹⁰ Hz/T pour l'électron). Ainsi, à 9 GHz le champ équivalent vaut environ 3,2 10⁻¹ T, valeur à comparer avec le champ magnétique terrestre qui est compris entre 30 et 70 microteslas.

Mesurer la largeur de la raie du matériau à caractériser autour de 9 GHz permet donc de négliger l'influence du champ magnétique terrestre. D'autre part, on sait que l'intensité du signal mesuré par le spectromètre est d'autant plus grande que la valeur de fr est élevée. Les mesures à des fréquences proches de la dizaine de gigahertz ne nécessitent pas l'emploi d'une circuiterie électronique sophistiquée puisque le signal très intense est facile à détecter.

Le fonctionnement des magnétomètres pour lesquels sont fabriqués les matériaux à classer est connu. Le matériau est soumis au champ magnétique Bo à mesurer et au champ magnétique d'amplitude Br, à la fréquence fr (radiofréquence) où l'on veut observer la résonance. On mesure en fait la dérivée de la courbe d'absorption (courbe de dispersion). Cette dérivée s'obtient en soumettant le matériau à un champ magnétique oscillant de faible amplitude Bm dans la direction de Bo (ou ce qui revient au même en modulant la fréquence fr) à une fréquence fm très inférieure à fr.

La figure 1 représente schématiquement une courbe d'absorption en fonction de la fréquence. C'est une courbe en cloche de type gaussienne centrée sur la valeur de Bo (qui équivaut à la fréquence fr par la relation fr = γBo). Sont aussi représentés la modulation dûe au champ Bm (suivant les ordonnées) et le signal résultant (suivant les abscisses).

La figure 2 représente schématiquement la courbe de dispersion ; elle présente dans sa partie centrale une zone linéaire qui est utilisée en magnétométrie.

Le classement des matériaux à grande densité de spins destinés à la magnétométrie par la comparaison de leur largeur de raie d'absorption mesurée à 9 GHz présente de nombreux inconvénients. La résolution du magnétomètre, donc la précison avec laquelle est mesurée le champ Bo, ne dépend pas seulement de la largeur Δ de raie. Le nombre de spins excités dans le matériau et le conditionnement de ce dernier dans le volume de détection jouent aussi un rôle. On conçoit donc que la caractérisation consistant à optimiser la largeur de la raie d'absorption n'est pas suffisante pour permettre une classification efficace des matériaux.

Dans le cas de ces matériaux à forte densité de spins, la mesure en fort champ (correspondant à une fréquence de référence de 9 GHz) s'effectue sur des quantités de matériau inférieures au microgramme. En effet, une plus grande quantité de matériau engendrerait un signal de résonance si intense que l'électronique de mesure serait saturée.

Avec de telles quantités, il est très délicat d'obtenir un conditionnement identique pour plusieurs échantillons du même matériau. Les performances d'un magnétomètre sont fonction de ce conditionnement par l'intermédiaire du couplage entre le volume du matériau et du circuit de mesure. Ainsi, deux magnétomètres utilisant le même matériau ne présentent pas obligatoirement les mêmes caractéristiques.

D'autre part, les mesures imprécises effectuées pour déterminer ces faibles quantités de matériaux interdisent de ramener les caractéristiques d'un magnétomètre (en particulier la valeur de la pente de la région centrale de la courbe de dispersion) à l'unité de masse. Enfin, on peut mettre en doute l'efficacité du classement d'échantillons dont le facteur de mérite est déterminé avec des masses différentes (et des conditionnements en volume différents).

Une fréquence de référence élevée est très éloignée des fréquences d'utilisation d'un magnétomètre (fréquences se situant au voisinage des valeurs du champ magnétique terrestre). Cet état de fait est un inconvénient car on sait que la largeur des raies d'absorption est une fonction de la fréquence. La saturation de la raie est différente à 9 GHz et à 2 MHz (valeur proche de celle équivalente au champ magnétique terrestre). Ce phénomène influence donc le classement des échantillons.

La présente invention a pour but de pallier ces divers inconvénients. Elle propose, par une mesure adaptée, de se placer dans les conditions d'utilisation des échantillons.

De façon plus précise, l'invention concerne un procédé de caractérisation d'un matériau pour son utilisation en magnétométrie à résonance.

Ce procédé consiste à soumettre ledit matériau à un champ magnétique de référence d'amplitude Br oscillant à une fréquence de référence fr, et à un champ magnétique continu de polarisation d'amplitude B1 perpendiculaire au champ magnétique de référence, l'un de ces deux champs magnétiques subissant une perturbation d'amplitude par un champ magnétique d'amplitude Bm et de fréquence fm, à tracer la courbe de dispersion du matériau autour de la fréquence de référence fr, cette courbe présentant une région centrale linéaire de pente maximale, et est caractérisé en ce que la fréquence de référence fr est voisine de la fréquence correspondant au champ terrestre local, dans une gamme allant de 1 à 2 MHz, en ce que le champ B1 est aligné sur le champ terrestre et en ce que l'on recherche la valeur maximale de la dite pente en faisant varier l'amplitude de la perturbation à la fréquence fm et l'amplitude Br du champ magnétique de référence.

La perturbation à fréquence fm peut être appliquée à l'un des deux champs magnétiques ; lorsqu'elle est appliquée au champ magnétique de polarisation d'amplitude B1, cette perturbation est un champ magnétique périodique de fréquence fm qui est ajouté audit champ de polarisation. Lorsqu'elle est appliquée au champ de référence d'amplitude Br, cette perturbation est une modulation à fréquence fm de la fréquence fr dudit champ de référence.

Le facteur de mérite d'un échantillon est donc la pente de la région centrale de la courbe de dispersion. Le classement des matériaux pour leur utilisation en magnétométrie s'effectue suivant la valeur de cette pente. L'échantillon préféré sera celui présentant la plus grande pente. Evidemment, la comparaison entre les différents échantillons doit être effectuée en fixant un certain nombre de paramètres. En particulier, le couplage entre le volume de l'échantillon et le dispositif de mesure doit être identique pour chaque échantillon. Cela signifie que le conditionnement doit être le même pour chaque échantillon testé.

Pour permettre une bonne caractérisation du matériau en vue d'une utilisation en magnétométrie, la fréquence de référence doit être voisine de la fréquence correspondant au champ terrestre local. Les avantages d'une mesure à une fréquence de référence comprise entre 1 et 2 MHz sont multiples. Le faible signal de résonance à ces fréquences autorise des quantités de matériau plus importantes que dans l'art antérieur. Cela permet de dominer le conditionnement du matériau. D'autre part, cette gamme de fréquences est proche des fréquences d'utilisation d'un magnétomètre.

La présente invention a aussi pour objet un spectromètre selon la Revendication 2, conçu pour la mise en oeuvre du procédé de caractérisation. Ce spectromètre comprend une tête à configuration de Bloch déterminant les trois axes de Bloch : le premier dans la direction du champ magnétique d'amplitude B1 auquel vient se superposer un champ magnétique de modulation Bm, le second dans la direction du champ de référence d'amplitude Br et le troisième dans l'axe de mesure. Ces trois directions sont orthogonales.

Le mesure s'effectue par l'intermédiaire d'une bobine de mesure reliée à une entrée d'un amplificateur-détecteur. Cet amplificateur-détecteur comprend un préamplificateur bas bruit, permettant d'amplifier le signal détecté, délivré sur ladite entrée de l'amplificateur-détecteur. La fréquence de référence fr étant comprise dans une gamme allant de 1 à 2 MHz, le signal de résonance est peu intense comparé à celui obtenu à 9 GHz. Cela implique l'utilisation d'un préamplificateur à faible bruit pour ne pas perturber le signal détecté. Ce préamplificateur délivre un signal amplifié sur une entrée d'un mélangeur. Une autre entrée de ce mélangeur est reliée à une sortie d'un oscillateur qui délivre un signal électrique à la fréquence de référence fr. Le mélangeur agit en fait comme une détection synchrone : il sépare la composante du signal détecté modulée à la fréquence fm de la composante à la fréquence fr. Le mélangeur délivre un signal électrique sur une sortie. Cette sortie est reliée à une entrée d'une détection synchrone à la fréquence de modulation. Le signal délivré par une sortie de la détection synchrone est traité par un calculateur afin de déterminer la valeur de la pente de la région centrale de la courbe de dispersion.

Selon un autre aspect du spectromètre conforme à l'invention, la tête à configuration de Bloch est orientable par rotation autour de deux axes. Cela permet d'aligner le champ magnétique continu d'amplitude B1 et le champ magnétique de modulation d'amplitude Bm sur le champ magnétique terrestre. On peut ainsi éviter une distorsion (dans le sens d'un élargissement) de la courbe mesurée au cours du balayage de la résonance.

Le spectromètre permet l'optimisation de la pente de la région centrale de la courbe de dispersion. Cela revient à optimiser l'amplitude de cette courbe. On doit, pour ce faire, procéder à un étalonnage préalable du spectromètre. La présente invention a donc aussi pour objet un procédé de calibration de ce spectromètre. Ce procédé consiste à appliquer sur la bobine de détection un champ magnétique de caractérisation dont les caractéristiques sont connues ; et à mesurer ensuite une tension délivrée aux bornes de ladite bobine pour différentes valeurs du champ de calibration.

Les caractéristiques et avantages de l'invention apparaîtront mieux après la description qui suit donnée à titre explicatif et nullement limitatif. Cette description se réfère à des dessins annexés sur lesquels :

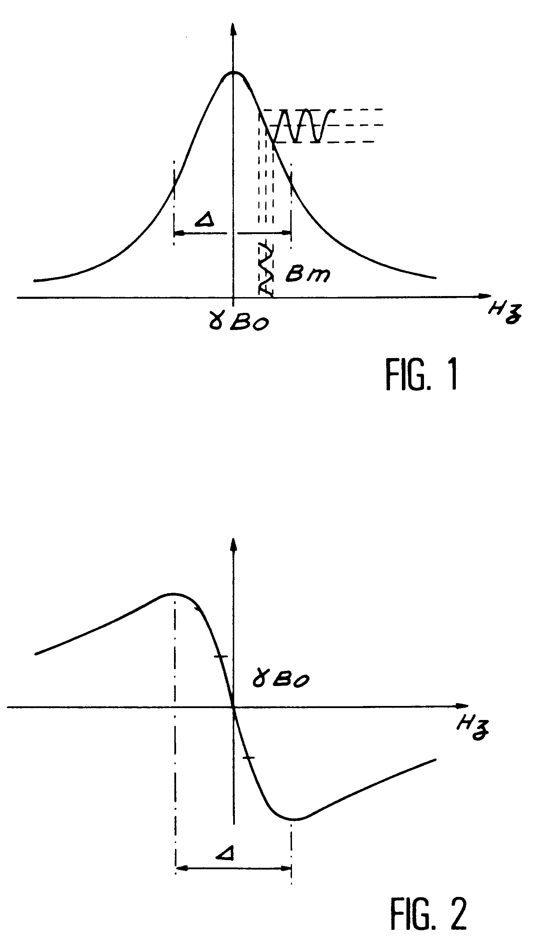

- la figure 1, déjà décrite, représente schématiquement une raie d'absorption d'un échantillon,
- la figure 2, déjà décrite, représente schématiquement une courbe de dispersion d'un échantillon,

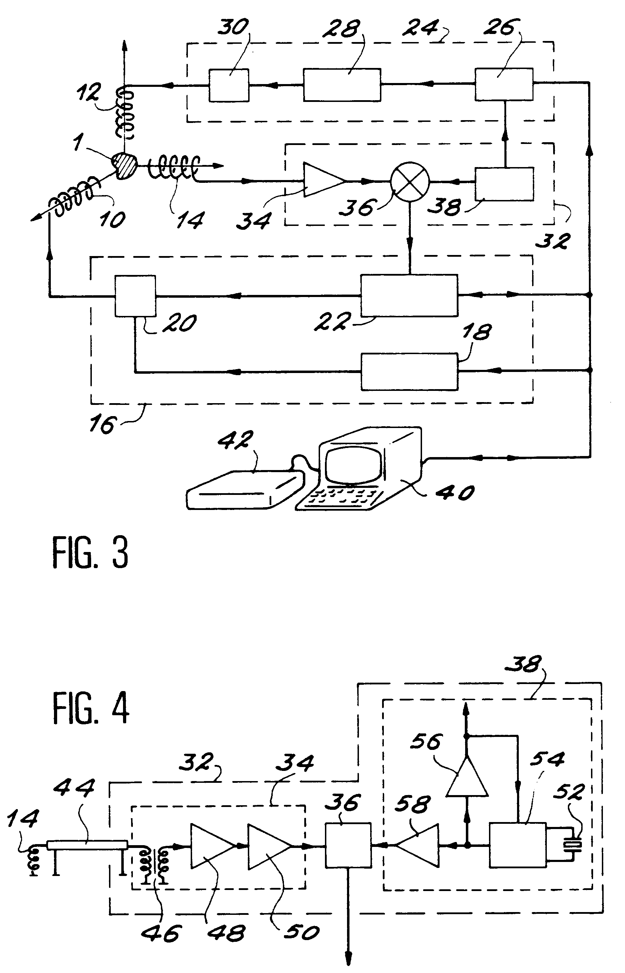

- la figure 3 représente schématiquement un sepctromètre conforme à l'invention,
- la figure 4 représente schématiquement un amplificateur-détecteur conforme à l'invention,

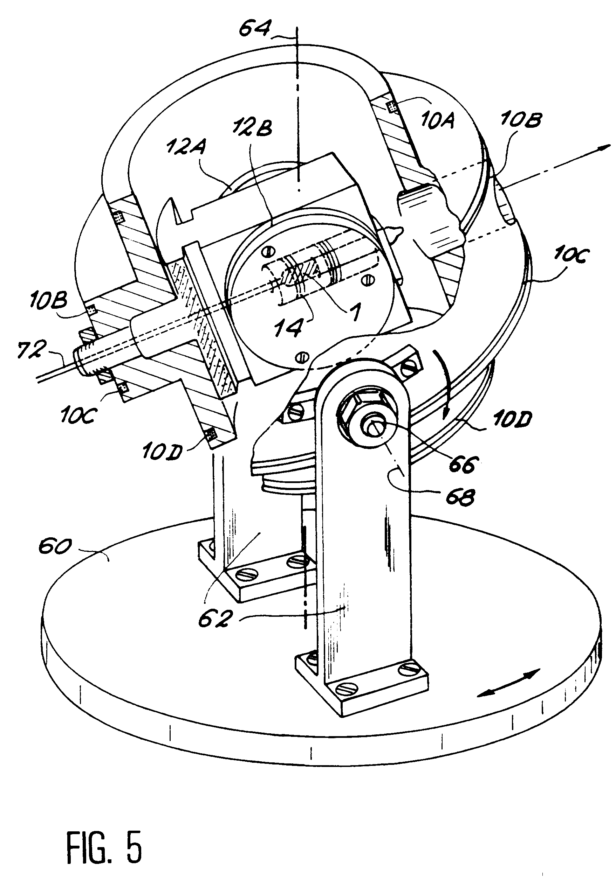

- la figure 5 représente schématiquement une tête de Bloch conforme à l'invention,

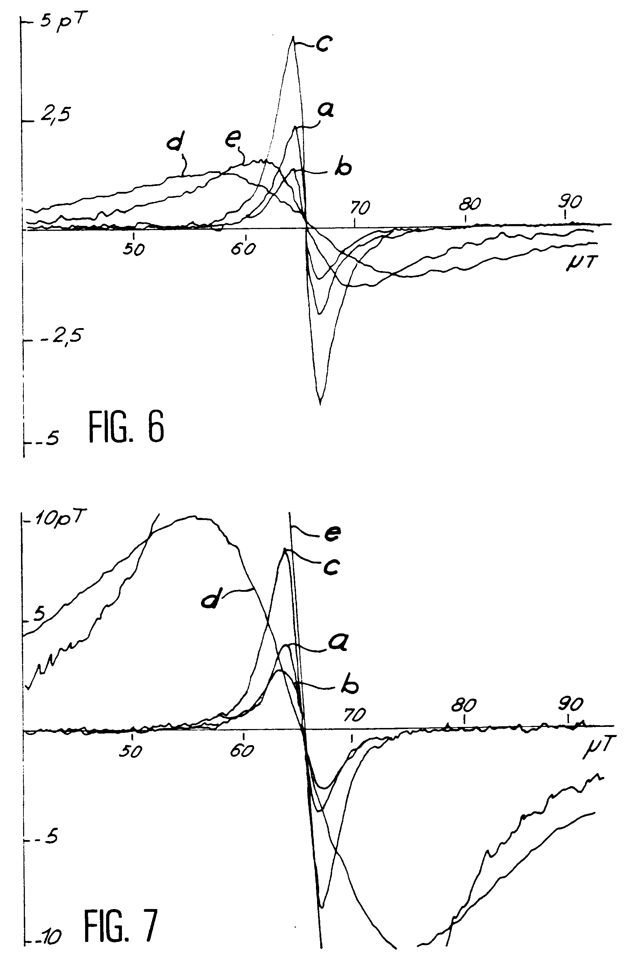

- la figure 6 représente schématiquement les courbes de dispersion de cinq matériaux, tracées conformément à l'art antérieur,

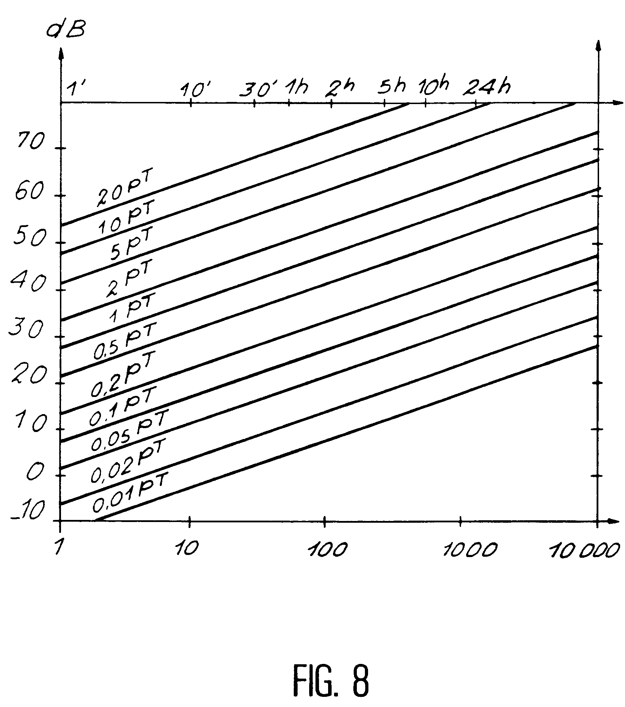

- la figure 7 représente schématiquement les courbes des dispersion de ces mêmes matériaux, tracées conformément au procédé de l'invention,
- la figure 8 représente schématiquement un réseau de courbes donnant le rapport signal sur bruit en fonction du nombre de moyennes effectuées par le calculateur ou du temps de balayage pour différentes valeurs de l'échelle choisie pour les ordonnées représentant l'amplitude de la courbe de dispersion.

La figure 3 représente schématiquement un spectromètre conforme à l'invention. Ce spectromètre comporte trois bobines 10, 12, 14 dont les axes sont perpendiculaires. L'échantillon à tester 1 est contenu à l'intérieur de ces bobines. La première bobine 10 est reliée à un circuit 16 de polarisation et de modulation. Elle engendre un champ magnétique de polarisation d'amplitude B1 superposé à un champ magnétique de modulation d'amplitude Bm oscillant à la fréquence fm. Le circuit 16 comporte une source de courant variable 18, un générateur de type 103A fabriqué par la Société Adret, par exemple. Cette dernière délivre un courant sur une sortie reliée à une entrée d'un coupleur 20. Ce coupleur 20 est d'autre part relié par une entrée à la sortie d'une détection synchrone 22, un modèle 5209 fabriqué par la Société E.G et G par exemple, qui délivre un signal électrique de modulation à la fréquence fm. Les deux signaux électriques sont additionnés dans le coupleur 20 qui est relié par une sortie à la bobine 10. Les courants délivrés par ledit coupleur engendrent les champs magnétiques de polarisation d'amplitude B1 et de modulation d'amplitude Bm. L'intensité du courant délivré par la source 18 varie de façon continue, entraînent des variations linéaires de l'amplitude du champ magnétique de polarisation. C'est ainsi qu'on peut tracer la courbe de dispersion en fonction des variations du champ B1. Le champ de modulation oscille à la fréquence fm, 270 Hz par exemple.

Le signal électrique délivré par la détection synchrone est d'intensité réglable, ce qui permet d'ajuster la valeur de l'amplitude Bm du champ de modulation.

La seconde bobine 12 est la bobine d'excitation. Elle engendre le champ magnétique de référence Br oscillant à la fréquence fr. Cette fréquence est comprise dans la gamme allant de 1 à 2 MHz. Elle est fixée à la valeur de 1,845 MHz, cette valeur correspond à un champ magnétique de 66 microteslas, valeur supérieure au champ terrestre local qui vaut 42 microteslas par exemple. Cette bobine 12 est reliée à un circuit 24 d'excitation à la fréquence fr. Ce circuit 24 comporte une chaîne de commande de l'amplitude du signal électrique à la fréquence fr délivré sur la bobine 12. Cette chaîne consiste en un atténuateur réglable 26 relié à un amplificateur radio-fréquence 28 de coefficient amplificateur égal à 40 dB par exemple, un modèle ARS 05-40-30 fariqué par la société SCD par exemple ; cette chaîne est reliée à un déphaseur 30 qui déphase le signal électrique délivré sur son entrée de π/2. Le déphasage introduit est utile à la détection du signal de résonance. Le déphaseur 30 est relié à la bobine 12 d'excitation.

La troisième bobine 14 est la bobine de détection. Elle est reliée à un amplificateur-détecteur 32. L'étage d'entrée de cet amplificateur 32 est constitué par un préamplificateur 34. La bobine 14 de détection délivre un signal sur l'entrée du préamplificateur 34. Le signal amplifié est délivré sur une sortie reliée à une entrée d'un mélangeur 36, un modèle TAK 3H fabriqué par la société MCL par exemple. Un oscillateur 38 délivre sur deux sorties un signal électrique à la fréquence de référence fr égale à 1,845 MHz par exemple. Une première de ces sorties est reliée à une entrée de l'atténuateur 26 compris dans la chaîne de commande de l'amplitude du signal électrique excitant la deuxième bobine 12. La seconde de ces sorties est reliée au mélangeur 36. Le mélangeur 36 sépare les diverses composantes du signal détecté. En particulier, il sépare la composante de faible intensité modulée à la fréquence fm de la composante intense modulée à la fréquence fr de référence. Cette dernière composante, parasite pour la mesure, est détectée par couplage direct entre les bobines 12 et 14.

Le mélangeur 36 délivre un signal électrique sur la détection synchrone 22. Cette dernière est reliée à un calculateur, un micro-ordinateur HP 9826 fabriqué par la société Hewlett Packard par exemple, muni d'une imprimante et d'un traceur graphique 42. Le calculateur permet de faire des moyennes sur plusieurs mesures, de filtrer les bruits parasites de la mesure, de délivrer directement la valeur de la pente, et toutes autres opérations classiques de traitement de fichiers. D'autre part, c'est par son intermédiaire que l'on commande à volonté l'intensité des signaux à la fréquence fm délivrés par la détection synchrone 22 et le coefficient d'atténuation de l'atténuateur réglable 26. Les courbes de dispersion correspondant aux différentes valeurs de paramètres intensité de la modulation et valeur de l'amplitude du champ magnétique B1 peuvent être tracées par l'imprimante ou le traceur graphique 42.

La figure 4 représente un schéma plus détaillé de l'amplificateur-détecteur. Le signal délivré par la bobine 14 à partir du signal de résonance de l'échantillon 1 est bien moins intense à 1,845 MHz qu'à 9 GHz. Cela impose certaines contraintes sur l'amplificateur-détecteur 32. En particulier le préamplificateur d'entrée 34 doit posséder une grande impédance d'entrée, un faible niveau de bruit et une bande passante très supérieure à 2 MHz.

La liaison entre la bobine 14 et l'amplificateur-détecteur 32 est assurée par un cable 44 coaxial amagnétique.

Le préamplificateur 34 comporte un transformateur d'impédance 46 qui permet de rendre le câble 44 transparent au signal délivré par la bobine 14. Ce transformateur 46 est relié à une entrée d'un amplificateur 48 à transistor à effet de champ, le modèle U 310 fabriqué par la société Siliconix, en montage cascade. Ce transistor à effet de champ est connecté avec un transistor BFY 90 fabriqué par la société Thomson par exemple. Cet amplificateur 48 est relié à une entrée d'un amplificateur 50 intégré bas bruit, SL 561 B fabriqué par la société Plessey.

Le préamplificateur 34 délivre un signal amplifié sur une entrée du mélangeur 36. Le mélangeur a aussi une entrée reliée à une sortie de l'oscillateur 38. Cet oscillateur 38 est composé d'un cristal 52 ayant une fréquence de résonance à 1,845 MHz. Ce cristal est connecté à un oscillateur sinusoïdal asservi 54. L'oscillateur 54 délivre un signal électrique sur deux amplificateurs 56, 58 d'impédance de sortie égale à 50 Ohms, un de ces amplificateurs 58 est relié au mélangeur 36.

Les divers éléments de l'amplificateur-détecteur 32 sont alimentés par une alimentation 15 fournissant la puissance nécessaire (non représentée sur la figure 4).

L'amplificateur-détecteur 32 crée donc le signal de référence à 1,845 MHz et le délivre à amplitude constante (l'oscillateur 54 est asservi) sur la chaîne de commande de l'amplitude du champ magnétique de référence. Il amplifie d'autre part, le signal en provenance de la bobine de détection (convenablement adaptée par le transformateur 46). Il réalise enfin une détection cohérente par l'intermédiaire du mélangeur 36. Les caractéristiques de cet amplificateur-détecteur 32 sont par exemple :

| | |
|---|---|
| impédance d'entrée : | 500 Ohms |
| bruit en tension : | 0,5 nV Hz^{-1/2} |
| impédance en sortie du mélangeur : | 50 Ohms |
| gain : | 585 |
| niveau de saturation à l'entrée : | 1,5 mV eff. |
| sortie de l'oscillateur reliée à l'atténuateur : | -5 dBm/50 Ohms |

La tête de mesure d'un spectromètre conforme à l'invention a une configuration de Bloch. La figure 5 représente schématiquement une telle tête de mesure. Cette dernière détermine autour de l'échantillon 1 les trois axes perpendiculaires de Bloch. Un premier axe se situe selon la direction du champ magnétique de polarisation ; un second s'aligne sur le champ magnétique de référence et le dernier est l'axe de mesure.

Le champ magnétique de polarisation doit se superposer au champ magnétique terrestre local. Pour obtenir un balayage linéaire en fonction du courant, l'axe de la bobine 10 engendrant le champ magnétique de polarisation (et de modulation) doit être aligné sur la direction du champ magnétique terrestre local.

Pour permettre cet alignement, la tête de mesure est orientable dans les trois directions de l'espace ; elle est montée sur un support en matériau amagnétique constitué par un plateau 60 circulaire sur lequel sont fixées deux pattes 62. Le plateau 60 est tournant autour d'un axe 64 perpendiculaire à la surface du plateau et passant en son centre. La tête est maintenue sur les pattes 62 par deux pivots 66 qui permettent la rotation autour d'un axe 68 reliant les deux pivots 66 et croisant perpendiculairement l'axe 64.

L'axe du champ terrestre est déterminé avec une précision de quelques degrés par un magnétomètre de type Forster par exemple. L'homogénéité du champ requise sur la dimension de l'échantillon doit être d'un ordre de grandeur meilleure que la largeur de raie maximale que l'on veut mesurer, c'est-à-dire environ 10⁻³ sur 1 cm³ par exemple. La bobine 10 est une bobine à champ homogène qui peut-être constituée de quatre bobinages 10A, 10B, 10C, 10D disposés par exemple de façon à obtenir un champ magnétique de polarisation d'amplitude B1 homogène comme cela est décrit par Kaminischi dans la revue Rev. Sci. Instrum. 52 (3), 447-453 (1981). La valeur de l'homogénéité le long de l'axe est inférieure à 10⁻⁵ sur 2 cm.

Cette bobine 10 présente par exemple les caractéristiques suivantes :

| | |
|---|---|
| résistance série : | 50 Ohms |
| inductance : | 4,7 mH |
| module de l'impédance à 1 kHz : | 58 Ohms |
| calibration (calculée) : | 754 microteslas/A |

Avec une alimentation de ± 100 mA par exemple et un champ local de 42 microteslas par exemple, on peut donc décrire un champ de -33 microteslas à 117 microteslas. A 1,845 MHz, la résonance est observée pour un courant de 31 mA.

La bobine 12 engendrant le champ magnétique de référence est réalisée par des bobinages 12A, 12B de Helmholtz. Ces bobines, alimentées en tension, doivent présenter une impédance beaucoup plus élevée que l'impédance du circuit d'excitation et une fréquence de résonance beaucoup plus éleve que la fréquence de référence.

Le diamètre des bobinages 12A, 12B en position de Helmholtz est de 60 mm par exemple. Elles sont faites chacune de 10 spires par exemple. Cette bobine 12 présente par exemple les caractéristiques suivantes :

| | |
|---|---|
| résistance série : | 20 Ohms |
| inductance : | 30 microhenrys |
| module de l'impédance à 1,845 MHz : | 348 Ohms |
| calibration (calculée) : | 280 microteslas/A |

La réalisation de la bobine 14 de détection ne peut se dissocier de celle de l'amplificateur-détecteur 32. Son rôle est prédominant pour l'obtention d'une grande sensibilité. Cette bobine 14 de détection présente des capacités parasites qui forment avec l'inductance de la bobine un circuit résonnant. La fréquence de résonance doit être supérieure ou égale à la fréquence de référence fr. La bobine 14 doit accueillir l'échantillon 1 à tester. Son volume intérieur peut aller de 0,01 cm³ à 2 cm³.

On peut citer, à titre d'exemple, une bobine 14 de détection présentant les caractéristiques suivantes :

| | |
|---|---|
| diamètre du bobinage : | 7,5 mm |
| nombre de spires : | 38 |
| longueur : | 10 mm |
| inductance : | 14,1 microhenrys |
| résistance (toutes pertes) : | 2,6 Ohms |

La bobine 14 est réalisée en fil divisé (multibrin) pour diminuer les pertes par effet de peau.

Optimiser la pente de la région centrale de la courbe de dispersion nécessite de savoir mesurer l'amplitude de cette courbe. Pour ce faire un étalonnage doit être effectué pour pouvoir associer à la tension mesurée par le calculateur une valeur de l'amplitude du champ détecté. Pour réaliser cette calibration, on applique un champ magnétique de calibration de caractéristiques connues simulant les champs de polarisation et de modulation. La tension aux bornes de la bobine de détection est mesurée pour différentes valeurs du champ de calibration.

Les échantillons 1 à tester sont sous forme de poudre polycristalline conditionnée dans une ampoule 70, scellée sous vide si la nature du matériau l'impose, qu'on introduit dans la tête de mesure. L'échantillon 1 est positionné à l'intersection des axes 64 et 68.

Une circulation de fluide caloporteur dans le tube 72 de maintien de l'ampoule 70 permet de faire des mesures à diverses températures. On peut faire circuler de l'hélium gazeux par exemple.

L'utilisation d'une fréquence de référence dans la gamme 1 à 2 MHz permet de tester des quantités de matériau facilement conditionnables. Le volume de l'échantillon est fixé entre 0,01 cm³ et 2 cm³. Pour une caractérisation rapide, un faible volume de 0,1 cm³ par exemple de matériau est suffisant. Si l'on veut étudier l'influence du conditionnement un volume de 1 cm³ par exemple est nécessaire.

Les variations de l'amplitude Br du champ magnétique de référence et de celle de l'amplitude, Bm, du champ magnétique de modulation pendant le balayage de la dispersion autour de la fréquence de référence, permettent d'optimiser la valeur de la pente de la région centrale de la courbe de dispersion. On obtient ainsi, pour un couple (Br, Bm) la valeur maximum de cette pente. La connaissance du volume de l'échantillon et, par conséquent, de sa masse permet de ramener les valeurs des pentes exprimées usuellement en Volt/Tesla (V/T) à l'unité de masse : elles sont donc exprimées en V/T/g.

La figure 6 représente schématiquement les courbes de dispersion de cinq matériaux. Ces courbes ont été optimisées conformément à l'art antérieur, c'est-à-dire en faisant varier les différents paramètres pour obtenir la largeur de raie d'absorption minimum pour chaque matériau.

La valeur de l'amplitude du champ de polarisation exprimée en microteslas (µT) est reportée en abscisses ; l'amplitude du champ détecté exprimée en picoteslas (pT) est reportée en ordonnées.

Les cinq courbes sont référencées a, b, c, d, e ; la courbe c correspond à un échantillon de naphtalène ; a correspond à un échantillon de fluoranthène ; b correspond à un échantillon de phtalocyanine de lithium (PcLi) ; e correspond à un échantillon de phtalocyanine substituée de lithium (PcLi subsituée) et d correspond à un échantillon en tétracyanoquinodiméthane quinoléïnium (TCNQ). Par cette méthode, le classement par ordre de mérite donne dans l'ordre de préférence : c, a, b, e, d.

La figure 7 représente schématiquement les courbes de dispersion pour les mêmes matériaux mais tracées en optimisant la pente et non plus la largeur de la raie. Par cette méthode, le classement par ordre de mérite devient : e = c, a, b = d. Pour les matériaux de cet exemple, e est donc le meilleur candidat, sachant que le matériau c est instable. De plus, à pente égale, une largeur de raie plus grande permet d'améliorer les performances dynamiques d'un magnétomètre (zone de linéarité plus grande).

La résolution d'un spectromètre conforme à l'invention peut s'exprimer de différentes manières. La figure 8 en donne un exemple. Elle représente schématiquement un réseau de courbes permettant de déduire le rapport signal/bruit en dB que l'on peut obtenir en fonction du temps (ou du nombre de moyennes effectuées par le calculateur) en fonction de la gamme choisie, de 0,01 pT pleine échelle à 20 pT pleine échelle. Le rapport signal/bruit est défini arbitrairement en faisant le rapport entre la pleine échelle et le bruit efficace en sortie avec filtrage au premier ordre.

La présente invention propose un procédé de caractérisation de matériaux pour leur utilisation en magnétométrie. Un spectromètre permet de mettre en oeuvre ce procédé : il fonctionne dans une gamme de fréquences proches de celles des magnétomètres. Le champ de polarisation varie linéairement en fonction d'un courant de commande. La détermination de la pente de la région centrale de la courbe de dispersion qui permet de comparer les échantillons est paramétrée par l'amplitude du champ de modulation et l'amplitude du champ de référence. Ce spectromètre donne les résultats suivants : la largeur de la raie d'absorption à la fréquence de référence, l'amplitude du champ mesuré et la valeur de la pente de la région centrale de la courbe de dispersion.

## Revendications

1. Procédé de caractérisation d'un matériau pour son utilisation en magnétométrie à résonance, consistant à soumettre ledit matériau à un champ magnétique de référence d'amplitude Br oscillant à une fréquence de référence fr, et à un champ magnétique continu de polarisation d'amplitude B1 perpendiculaire au champ magnétique de référence, l'un de ces deux champs magnétiques subissant une perturbation d'amplitude par un champ magnétique d'amplitude Bm et de fréquence fm, à tracer la courbe de dispersion du matériau autour de la fréquence de référence fr, cette courbe présentant une région centrale linéaire de pente maximale, caractérisé en ce que la fréquence de référence fr est voisine de la fréquence correspondant au champ terrestre local, dans une gamme allant de 1 à 2 MHz, en ce que le champ B1 est aligné sur le champ terrestre et en ce que l'on recherche la valeur maximale de la dite pente en faisant varier l'amplitude de la perturbation à la fréquence fm et l'amplitude Br du champ magnétique de référence.

2. Spectromètre conçu pour la mise en oeuvre du procédé selon la revendication 1, comprenant une tête de mesure à configuration de Bloch, orientable par rotation autour de deux axes (64,68), cette tête étant constituée de trois bobines (10, 12, 14) dirigées selon trois axes perpendiculaires entre eux, la première bobine (10) engendrant le champ magnétique de polarisation d'amplitude B1 superposé à un champ magnétique de perturbation d'amplitude Bm, la seconde bobine (12) engendrant le champ magnétique de référence d'amplitude Br, à la fréquence fr voisine de la fréquence correspondant au champ terrestre local dans une gamme allant de 1 à 2 MHz, la troisième bobine (14) étant une bobine de détection, la première bobine (10) étant reliée à une sortie d'un circuit (16) de polarisation et de perturbation la seconde bobine (12) étant reliée à un circuit (22) d'excitation à la fréquence de référence, les circuits (16, 24) de polarisation, de perturbation et d'excitation étant reliés à un calculateur (40), la bobine de détection (10) étant reliée à un amplificateur-détecteur (32), l'amplificateur-détecteur (32) comportant, relié par une entrée à la bobine de détection (14), un préamplificateur (34) délivrant sur une sortie un signal électrique amplifié vers la deuxième entrée d'un mélangeur (36) ; un oscillateur (38) délivrant sur une sortie un signal électrique à la fréquence de référence ; le mélangeur (36), relié par une première entrée à une sortie de l'oscillateur (38) et délivrant un signal électrique sur une sortie reliée à une entrée du circuit (16) de polarisation et de perturbation.

3. Spectromètre selon la revendication 2, caractérisé en ce que la tête à configuration de Bloch est équipée d'un tube (72) assurant la circulation d'un fluide caloporteur.

4. Spectromètre selon la revendication 2, caractérisé en ce que la tête à configuration de Bloch est montée sur un support en matériau amagnétique comprenant un plateau (60) circulaire tournant autour d'un axe (64) perpendiculaire audit plateau (60) et passant par son centre et deux pattes (62) fixées sur le plateau (60) à égale distance du centre du plateau (60) et disposées en regard le long d'un diamètre du plateau (60) ; et en ce que la tête est maintenue sur les pattes (62) par deux pivots (66) permettant la rotation de la tête autour d'un axe (68) reliant les deux pivots (66) et croisant perpendiculairement l'axe (64) perpendiculaire au plateau (60).

5. Spectromètre selon la revendication 2, caractérisé en ce que la troisième bobine (14) présentant une fréquence de résonance, cette fréquence de résonance est supérieure ou égale à la fréquence de référence fr. 2

6. Spectromètre selon la revendication 2, caractérisé en ce que la troisième bobine (14) présente un volume intérieur allant de 0,01 cm³ à 2 cm³.

7. Spectromètre selon la revendication 2, caractérisé en ce que la première bobine (10) est une bobine à champ homogène comportant quatre bobinagess (10A, 10B, 10C, 10D).

8. Spectromètre selon la revendication 2, caractérisé en ce que la seconde bobine (12) est une bobine de Helmholtz comportant deux bobinages (12A, 12B).

## Claims

1. Method for characterizing a material for its use in resonance magnetometry, consisting in subjecting the said material to a reference magnetic field of amplitude Br oscillating at a reference frequency fr, and to a continuous polarization magnetic field of amplitude B1 perpendicular to the reference magnetic field, one of these two magnetic fields undergoing an amplitude perturbation by a magnetic field of amplitude Bm and of frequency fm, in plotting the dispersion curve of the material around the reference frequency fr, this curve having a central linear region of maximum slope, characterized in that the reference frequency fr is close to the frequency corresponding to the local field of the Earth, in a range of 1 to 2 MHz, and in that the field B1 is aligned on the field of the Earth and in that the maximum value of the said slope is looked for by varying the amplitude of the perturbation at the frequency fm and the amplitude Br of the reference magnetic field.

2. Spectrometer designed for implementing the method according to Claim 1, comprising a measurement head with Bloch configuration, which can be directed by rotating around two axes (64, 68), this head consisting of three coils (10, 12, 14) directed along three mutually perpendicular axes, the first coil (10) generating the polarization magnetic field of amplitude B1 superimposed with a perturbation magnetic field of amplitude Bm, the second coil (12) generating the reference magnetic field of amplitude Br, at the frequency fr close to the frequency corresponding to the local field of the Earth in a range from 1 to 2 MHz, the third coil (14) being a detection coil, the first coil (10) being connected to one output of a polarization and perturbation circuit (16), the second coil (12) being connected to a circuit (24) for excitation at the reference frequency, the polarization, perturbation and excitation circuits (16, 24) being connected to a computer (40), the detection coil (10) being connected to an amplifier/detector (32), the amplifier/detector (32) comprising, connected to an input of the detection coil (14), a preamplifier (34) delivering on an output an amplified electrical signal to the second input of a mixer (36); an oscillator (38) delivering on an output an electrical signal at the reference frequency; the mixer (36), connected by a first input to an output of the oscillator (38) and delivering an electrical signal on an output connected to an input of the polarization and perturbation circuit (16).

3. Spectrometer according to Claim 2, characterized in that the head with Bloch configuration is equipped with a tube (72) ensuring circulation of a heat-exchange fluid.

4. Spectrometer according to Claim 2, characterized in that the head with Bloch configuration is mounted on a support made of a non-magnetic material, comprising a circular plate (60) rotating about an axis (64) perpendicular to the said plate (60) and passing through its centre and two legs (62) fixed on to the plate (60) at an equal distance from the centre of the plate (60) and arranged facing each other along a diameter of the plate (60); and in that the head is held on the legs (62) by two pivots (66) allowing rotation of the head about an axis (68) connecting the two pivots (66) and crossing the axis (64) perpendicular to the plate (60) at right angles.

5. Spectrometer according to Claim 2, characterized in that, the third coil (14) having a resonant frequency, this resonant frequency is greater than or equal to the reference frequency fr.

6. Spectrometer according Claim 2, characterized in that the third coil (14) has an internal volume of from 0.01 cm³ to 2 cm³.

7. Spectrometer according Claim 2, characterized in that the first coil (10) is a coil with homogeneous field comprising four windings (10A, 10B, 10C, 10D).

8. Spectrometer according Claim 2, characterized in that the second coil (12) is a Helmholtz coil comprising two windings (12A, 12B).

## Patentansprüche

1. Verfahren zur Charakterisierung eines Stoffes für seine Verwendung bei der Resonanz-Magnetometrie, darin bestehend, den Stoff einem magnetischen Referenzfeld der Amplitude Br, das mit einer Referenzfrequenz fr schwingt, sowie einem magnetischen Gleichfeld zur Polarisation mit der Amplitude B1 zu unterwerfen, das senkrecht zum magnetischen Referenzfeld ist, wobei eines dieser beiden magnetischen Felder eine Störung der Amplitude durch ein magnetisches Feld der Amplitude Bm und der Frequenz fm erfährt, um die Dispersionskurve des Stoffes im Bereich der Referenzfrequenz fr aufzuzeichnen, wobei diese Kurve einen zentralen linearen Bereich mit maximaler Steigung besitzt,
dadurch gekennzeichnet, daß die Referenzfrequenz fr in der Nähe der dem lokalen Erdfeld entsprechenden Frequenz in einem Bereich von 1 bis 2 MHz liegt, daß das Feld B1 auf das Erdfeld ausgerichtet wird und daß man den Maximalwert genannter Steigung sucht, indem man die Amplitude der Störung bei der Frequenz fm und die Amplitude Br des magnetischen Referenzfeldes variieren läßt.

2. Spektrometer, konzipiert für die Durchführung des Verfahrens nach Anspruch 1, umfassend einen durch Drehung um seine zwei Achsen (64, 68) orientierbaren Meßkopf in Bloch-Konfiguration, wobei dieser Kopf aus drei Spulen (10, 12, 14) besteht, die nach drei zueinander senkrechten Achsen ausgerichtet sind, wobei die erste Spule (10) das magnetische Feld zur Polarisation mit der Amplitude B1 erzeugt, das einem magnetischen Störfeld der Amplitude Bm überlagert wird, die zweite Spule (12) das magnetische Referenzfeld der Amplitude Br mit einer Frequenz fr in der Nähe der dem lokalen Erdfeld entsprechenden Frequenz in einem Bereich von 1 bis 2 MHz erzeugt, während die dritte Spule (14) eine Detektionsspule ist, wobei die erste Spule (10) mit einem Ausgang einer Schaltung (16) zur Polarisation und Störung verbunden ist und die zweite Spule (12) mit einer Schaltung (24) zur Anregung mit der Referenzfrequenz verbunden ist, wobei die Schaltungen (16, 24) zur Polarisation, zur Störung und zur Anregung mit einem Rechner (40) verbunden sind, die Detektionsspule (14) mit einem Verstärker-Detektor (32) verbunden ist, der einen über einen Eingang mit der Detektionsspule (14) verbundenen Vorverstärker (34) umfaßt, der an einem Ausgang ein verstärktes elektrisches Signal zu dem zweiten Eingang einer Mischstufe (36) liefert, wobei ein Oszillator (38) an einem Ausgang ein elektrisches Signal mit der Referenzfrequenz liefert, während die Mischstufe (36), die durch einen ersten Eingang mit dem Ausgang des Oszillators (38) verbunden ist, ein elektrisches Signal an einem Ausgang liefert, der mit einem Eingang der Schaltung (16) zur Polarisation und zur Störung verbunden ist.

3. Spektrometer nach Anspruch 2, dadurch gekennzeichnet, daß der Kopf in Bloch-Konfiguration mit einem Rohr (72) ausgerüstet ist, welches das Umwälzen einer wärmeübertragenden Flüssigkeit sicherstellt.

4. Spektrometer nach Anspruch 2, dadurch gekennzeichnet, daß der Kopf in Bloch-Konfiguration auf einen Träger aus unmagnetischem Material montiert ist, der eine kreisförmige Platte (60), die sich um eine zur Platte (60) senkrechte, durch ihren Mittelpunkt gehende Achse (64) dreht, sowie zwei Füße (62) umfaßt, die auf der Platte (60) in gleicher Entfernung vom Mittelpunkt der Fläche (60) befestigt sind und entlang einem Durchmesser der Platte (60) gegenüberstehend angeordnet sind,
und daß der Kopf an den Füßen (62) durch zwei Drehzapfen (66) gehalten wird, die die Rotation des Kopfes um eine Achse (68), die die beiden Drehzapfen (66) verbindet und die die zur Platte (60) senkrechte Achse (64) senkrecht schneidet, erlauben.

5. Spektrometer nach Anspruch 2, dadurch gekennzeichnet, daß die dritte Spule (14) eine Resonanzfrequenz besitzt, wobei diese Resonanzfrequenz größer oder gleich der Referenzfrequenz fr ist.

6. Spektrometer nach Anspruch 2, dadurch gekennzeichnet, daß die dritte Spule (14) ein Innenvolumen besitzt, das von 0,01 cm³ bis 2 cm³ geht.

7. Spektrometer nach Anspruch 2, dadurch gekennzeichnet, daß die erste Spule (10) eine Spule mit homogenem Feld ist, die vier Wicklungen (10A, 10B, 10C, 10D) umfaßt.

8. Spektrometer nach Anspruch 2, dadurch gekennzeichnet, daß die zweite Spule (12) eine Helmholtz-Spule ist, die zwei Wicklungen (12A, 12B) umfaßt.
